(19) Europäisches Patentamt
European Patent Office
Office européen des brevets

(11) **EP 0 913 951 A2**

## (12) EUROPEAN PATENT APPLICATION

(43) Date of publication:
06.05.1999 Bulletin 1999/18

(51) Int. Cl.$^6$: **H04B 1/10**

(21) Application number: 98119703.1

(22) Date of filing: 19.10.1998

(84) Designated Contracting States:
AT BE CH CY DE DK ES FI FR GB GR IE IT LI LU MC NL PT SE
Designated Extension States:
AL LT LV MK RO SI

(30) Priority: 31.10.1997 DE 19748187

(71) Applicant:
DEUTSCHE THOMSON-BRANDT GMBH
78048 Villingen-Schwenningen (DE)

(72) Inventor: **Varga, Imre**
**81477 München (DE)**

(74) Representative:
**Hartnack, Wolfgang, Dipl.-Ing.**
**Deutsche Thomson-Brandt GmbH**
**Licensing & Intellectual Property,**
**Karl-Wiechert-Allee 74**
**30625 Hannover (DE)**

(54) **Method for suppressing narrow-band, fixed-frequency interference in an audio signal**

(57) Audio signals frequently contain narrow-band interference, which can be eliminated by notch filters. In this case, the notch frequency must be set to the respective interference frequency. Adaptive filters are particularly well suited for this purpose. In order to prevent erroneous adaptation to parts of the useful signal, and thus a palpable impairment of the useful signal, the adaptation of notch filtering according to the invention is performed when no audio signal or only a small one is present. The adaptation is terminated, and the coefficients of the adaptive notch filtering which were determined in the adaptation are retained when the interference frequency has been determined and the desired filter characteristic has been reached. The audio signal is then filtered using the retained coefficients. It is advantageous to use an IIR notch filter in direct form for the adaptive notch filtering. Furthermore, it is preferred for the filter coefficients which are related to the interference frequency to be averaged during or after the adaptation by means of low-pass filtering, and for the averaged filter coefficients to be used for the notch filtering.

## Description

The invention relates to a method for suppressing narrow-band, fixed-frequency interference in an audio signal by means of adaptive notch filtering, in particular by means of an IIR notch filter in direct form.

Prior art

Audio signals such as, for example, music or speech frequently contain narrow-band interference when they are recorded or reproduced. This can be, for example, a 50-Hz or 60-Hz hum owing to inadequate screening of the power supply system, hum harmonics or interference from lighting systems. As a rule, the frequency of this interference is either constant or varies only slightly over time. Consequently, the generally sinusoidal interference components can be eliminated from the audio signal by means of one or more notch filters of high pole Q. Here, the notch frequency must be set to the respective interference frequency. Adaptive filters, which by comparison with the settable notch filter find the notch frequency automatically, that is to say require no tiresome setting of the notch frequency by hand, are particularly suitable for this purpose.

Such a filter is described in BHASKAR D. RAO, R. Peng, "Tracking Characteristics of the Constrained IIR Adaptive Notch Filter", IEEE Trans. Acoust., Speech, Signal Processing, vol. 36, No. 9, September 1988, pages 1466-1479. There, use is made of an IIR notch filter in direct form for the adaptive notch filtering. The coefficients of the IIR notch filter are determined by means of a Gauss-Newton algorithm with a constant step width. The adaptation is carried out continuously in this case, in order to permit tracking of the notch frequency in the event of a change in the interference frequency.

Such a continuous adaptation of the notch filter is required in the case of a variable interference frequency. However, in the case of an interference frequency which is essentially fixed this is not sensible because it is not necessarily always the interference signal which is eliminated but, as the case may be, a part of the useful signal. The reason for this is that the notch frequency is controlled to the sinusoidal component having the highest level, to be precise independently of whether this is the interference signal or a part of the useful signal. It is thus possible, above all in the case of low interference levels, for there to be a marked impairment of the useful signal owing to erroneous adaptation and filtering.

Invention

It is therefore the object of the invention to specify a method for suppressing narrow-band, fixed-frequency interference in an audio signal by means of adaptive notch filtering which does not lead to the described impairment of the useful signal. This object is achieved by means of the method specified in Claim 1.

In principle, the inventive method for suppressing narrow-band, fixed-frequency interference in an audio signal by means of adaptive notch filtering in which the interference frequency is determined automatically consists in that the adaptation of the notch filtering is performed when no audio signal or only a small one is present, the adaptation being terminated and a parameter, which determines the notch frequency and is determined in the adaptation, of the adaptive notch filtering being retained when the interference frequency has been determined, and in that the notch filtering of the audio signal is carried out using the retained parameter which determines the notch frequency.

The method according to the invention therefore makes use of the finding that the interference is also present during the pauses in the useful signal or before the start of the useful signal. An adaptation can therefore be performed for fixed-frequency interference even at these instants. After such an adaptation phase, it is then necessary for the adaptation to be frozen to a certain extent, that is to say the coeffients must retain their respective value instead of being newly, and thus possibly once again wrongly, defined during the useful signal phase.

In the method according to the invention, it is advantageous to make use for the adaptive notch filtering of an IIR notch filter in direct form, since because of its simple adaptation scheme and favourable filter characteristics the latter is particularly well suited for eliminating narrow-band interference.

In accordance with an advantageous embodiment of the subject-matter of the invention, filter coefficients which are related to the interference frequency are averaged during or after the adaptation by means of low-pass filtering, and the averaged filter coefficients are used for the notch filtering. This is particularly advantageous since the filter coefficients vary continuously during the adaptation, with the result that in the event of a sudden termination of the adaptation from one discrete instant to the next the filter coefficients assume only an instantaneous value close to the desired value. Although these can still remain acceptable given a low pole Q, they are not particularly well suited to selective notch filtering. By contrast, owing to the averaging, the notch frequency is very accurately tuned to the interference frequency after termination of the adaptation.

It can be advantageous in this case to carry out the averaging only during the last phase of the adaptation, since during the adaptation the interference frequency can initially be determined only coarsely, and a precise determination of the interference frequency can be performed only towards the end of the adaptation.

The cut-off frequency of the low-pass filtering is preferably selected as a function of the interference frequency determined. By virtue of a continuously optimised value of the cut-off frequency, this permits good attenuation at the interference frequency and, simultaneously, a short averaging time, since the time constant of low-pass filters is inversely related to the cut-off frequency. Thus, the cut-off frequency can, for example, be selected at a fixed proportion of the interference frequency such as, for example, by a decade lower.

It is particularly advantageous in this case to use a low pass of second order for the low-pass filtering.

Finally, it is particularly advantageous to vary the filter characteristic of the notch filtering during the adaptation and to retain the parameter, which determines the notch frequency, of the adaptive notch filtering when the desired filter characteristic of the notch filtering has been reached in addition to the interference frequency. In this case, the bandwidth of the notch of the notch filtering is preferably reduced during the adaptation. In this way, the interferer can be more effectively found using a notch which is initially opened further. During the adapation, the notch is then narrowed, thus increasing the frequency accuracy, and the impairment of the audio signal is thereby reduced.

## Exemplary embodiments

A notch filter in direct form, also known as a constrained IIR notch filter, can be used to filter out a single linear interferer. The transfer function of such a filter is given by

$$H(z) + \frac{A(z)}{A(z/r)} = \frac{1+a*z^{-1}+z^{-2}}{1+a*r*z^{-1}+r^{2}*z^{-2}}$$

where

$a = -2*\cos(2**f0/fs)$
f0 is the notch frequency
fs is the sampling frequency and
r is the absolute value of the pole points.
r determines the bandwidth of the notch, and a high pole Q and thus a small bandwidth implies r close to 1 (for example r=0.999). The relationship between r and the bandwidth df is

$$r^{2} = (1\text{-}\tan(\pi*df/fs))/(1+\tan(\pi*df/fs))$$

The pole Q is given in this case by Q=f0/df .

Numerous algorithms are known for the adaptation of the adaptive FIR filters. Thus, the LMS algorithm and the NLMS algorithm (LMS = Least Mean Squares; NLMS = Normalized LMS), which both belong to the stochastic gradient methods, represent two important basic algorithms most frequently used in practical applications. In the NLMS algorithm, the step size is normalised to the power of the input signal, the adaptation characteristics thereby being independent of the signal level. Clear advantages result from this in applications where non-stationary signals, for example speech or music, must be processed. Similarly, it is also possible in the case of the invention to use a stochastic approximation to determine the gradient. A simple LMS-like adaptation is given, for example, by

$$a(n+1) = a(n)+mu*e(n)*\{r*e(n\text{-}1)\text{-}x(n\text{-}1)\}$$

where

mu is the step size,
x(n) is the notch filter input signal, and
e(n) is the notch filter output signal.

However, it is also possible to use other adaptation methods. In particular, it can be advantageous to normalise by means of an NLMS-like adaptation. Gauss-Newton recursions can more effectively support the convergence to the global optimum.

A change in r during the adaptation for the purpose of reducing the bandwidth of the notch or the notch filtering can be selected, for example, in accordance with

$$r(n+1) = 1*r(n)+(l-1)*r(inf)$$

where r(inf)>r(0), l = close to 1.

After the convergence to the adaptation, the sequence {a(n)} is preferably averaged by means of a low-pass filter. This is the more important the higher the pole Q and, correspondingly, the smaller the bandwidth. Filtering which is as narrow-band as possible is, in turn, necessary in order to impair the useful signal as little as possible. After an averaging time corresponding to the parameters of the filter, the adaptation is then stopped, and the parameter a assumes its averaged value.

If possible, for example, to use a low-pass filter of second order (biquad):

$$L(z) \; \simeq \; \frac{a0*(1+2*z^{-1}+z^{-2})}{1+b1*z^{-1}+b2*z^{-2}} \; .$$

In this case, the coefficients must be selected such that the cut-off frequency and the pole Q correspond to the opposing requirements of the accuracy of the notch frequency and the duration of the averaging. For example, the low-pass filter can be dimensioned as follows after the bilinear transformation:

$$\pi*f0/fs = (1/2)*arccos(-a/2)$$

where a=a(n) is the adapted parameter of the notch filter

$$k = 1/tan(\pi*c*f0/fs).$$

It is also possible in this case to approximate the arccos. Furthermore, in the case of certain values of c k can be calculated directly from a by trigonometric transformations. For example, c can have a value of 0.1, and in this case the cut-off frequency of the low-pass filter is a decade below the interference frequency.

The further parameters can be selected as follows:

$$Q = 1/sqrt(2)$$

$$a0 = 1/(1+k/Q+k^2)$$

$$b1 = 2*a0*(1-k^2)$$

$$b2 = (1-k/Q+k^2)/(1+k/Q+k^2)$$

Finally, several linear interferers in the signal can be eliminated simultaneously by sequential use of several notch filters in cascade. The individual notch filters are adapted in this case one after another.

The invention can be applied in the reproduction and/or recording of speech signals and music signals. In particular, it can be applied in different recording devices of entertainment electronics such as, for example, cassette units and tape units, as well as devices for playing back and/or recording optical storage disks. Likewise, the invention can be implemented in a single unit specially provided for the purpose, or in a component of a personal computer.

## Claims

1. Method for suppressing narrow-band, fixed-frequency interference in an audio signal by means of adaptive notch filtering, in particular by means of an IIR notch filter in direct form, in which the interference frequency is automatically determined, characterized in that

   - the adaptation of the notch filtering is performed when no audio signal or an audio signal of only a small amplitude is present;

- the adaptation is terminated and at least one parameter, which determines the notch filter and is determined in the adaptation, of the adaptive notch filtering is retained when the interference frequency and/or interference amplitude has been determined; and

- the notch filtering of the audio signal is carried out using the retained parameter which determines the notch filter.

2. Method according to Claim 1, characterized in that filter coefficients which are related to the interference frequency are averaged during or after the adaptation by means of low-pass filtering, and the averaged filter coefficients are used for the notch filtering.

3. Method according to Claim 2, characterized in that the averaging is carried out only during the last phase of the adaptation.

4. Method according to Claim 2 or 3, characterized in that the cut-off frequency of the low-pass filtering is selected as a function of the interference frequency determined.

5. Method according to one of Claims 2 to 4, characterized in that a low-pass filter of second order is used for the low-pass filtering.

6. Method according to one of the preceding claims, characterized in that the filter characteristic of the notch filtering is changed during the adaptation and the parameter, which determines the notch frequency, of the adaptive notch filtering is retained when the desired filter characteristic of the notch filtering has been reached in addition to the interference frequency.

7. Method according to Claim 6, characterized in that the bandwidth of the notch of the notch filtering is reduced during the adaptation.